# EUROPEAN PATENT APPLICATION

(11) **EP 2 816 394 A1**
(43) Date of publication of application: **24.12.2014**
(21) Application number: 12852475.8
(22) Date of filing: 28.11.2012
(51) Int. Cl.: G02F 1/1335, G03F 7/20, F21V 8/00

(54) **LIGHT GUIDE PLATE LATTICE POINT MANUFACTURING METHOD, LIGHT GUIDE PLATE MANUFACTURING METHOD, BACKLIGHT MODULE, AND DISPLAY APPARATUS**

(30) Priority: 09.01.2012 CN 201210005171
(71) Applicant: BOE Technology Group Co., Ltd., Beijing 100016 (CN); BOE Optical Science And Technology Co., Ltd., Suzhou, Jiangsu 215021 (CN)
(72) Inventor: LONG, Dengwu, Beijing 100176 (CN)
(74) Representative: Brötz, Helmut
(86) International application number: PCT/CN2012/085481
(87) International publication number: WO 2013/104216

(57) **Abstract**

The present disclosure provides a fabricating method of grid points on light guiding plate, a fabricating method of light guiding plate, and a backlight module and a display device. The fabricating method of grid points on a light guiding plate. The fabricating method of grid points on a light guiding plate comprises following steps of: S1, forming a layer of photosensitive material on a mold for the light guiding plate; and S2, performing photolithography on the photosensitive material in order to form grid points on the light guiding plate. According to present disclosure, since the mold for the light guiding plate is not etched directly, but the grid points is formed on the layer of photosensitive resist applied on the mold, therefore the grid points on the light guiding plate can be made without damaging the surface of the mold for the light guiding plate, and the cost for polishing the mold surface is saved and the overall process is simplified.

## Description

### FIELD

The present disclosure relates to a field of display technology, in particular to a fabricating method of grid points on light guiding plate, a fabricating method of light guiding plate, and a backlight module and a display device.

### BACKGROUND

Light guiding plate has a main function of guiding lights to intended directions by designers of display device. Therefore it is the most important and technologies bearing part in a backlight module, especially in a backlight module in which lights from the light sources are incident on the side surfaces of the light guiding plate. Fabricating methods of light guiding plate can be divided into printing methods and non printing methods based on how to make grid points (including microstructures array) on light guiding plate. In the printing method, the grid points are printed on a reflective surface of the light guiding plate by a printing method after molding of the light guiding plate. In the non printing method, the grid points are directly molded on the reflective surface during molding of the light guiding plate. For example, the designed grid points are made on a mold for the light guiding plate so that the grid points and the light guiding plate body can be molded at the same time during injecting molding process. In an example, a batch of optical grade particles of raw materials such as PC (polycarbonate) or PMMA (polymethacrylate) is introduced into a mold under high pressure at elevated temperatures in an injection molding machine and molded so as to form grid points on at least one surface of the light guiding plate after cooling down. The grid points diffuse lights impinging thereon into various directions and the diffused lights are thus emitted from light emitting surface of the light guiding plate. It is necessary to control both diameter and distribution density of the grid points on the light guiding plate in order to achieve a uniform radiation from the light guiding plate.

There are various conventional fabricating methods of the grid points on the light guiding plate typically utilizing chemical etching and laser etching. By chemical etching and laser etching, a plurality of recesses are etched on a mirror surface of the mold for light guiding plate in order to make grid points on the light guiding plate, thus the surface of the mold for light guiding plate is destroyed. Therefore, the mold for light guiding plate can not be reused, which increase cost and complicate process.

### SUMMARY

The embodiment of the present disclosure provides a fabricating method of grid points on a light guiding plate, comprising following steps of: S1, forming a layer of photosensitive material on a mold for the light guiding plate; and S2, performing photolithography on the photosensitive material in order to form grid points on the light guiding plate.

In one example, the photosensitive material is a photosensitive resist.

In one example, the step of S1 further comprises following steps of: S11, performing arefaction on the mold for the light guiding plate; S12, applying the photosensitive resist on the surface of the mold for the light guiding plate; and S13, removing a solvent in the photosensitive resist.

In one example, in the step of S13, the solvent in the photosensitive resist is removed by a soft baking method.

In one example, the step of S2 further comprises: using a film formed with grid points arrangement pattern as a mask, sequentially performing exposing and developing processes on the photosensitive resist in order to form a grid points pattern on the photosensitive resist, and curing the photosensitive resist and removing residual solvent and moisture.

In one example, in step of S22, the photosensitive resist is exposed with UV radiation.

The embodiment of the present disclosure provides a fabricating method of a light guiding plate, comprising following steps of: A3, fabricating grid points on the mold for the light guiding plate according to the fabricating method of grid points on a light guiding plate as described above, loading the mold for the light guiding plate formed with grid points into a mold case for the light guiding plate and obtaining the light guiding plate by injection molding with the mold.

In one example, prior to the step of A3, the method further comprising following steps: A1, designing the grid points arrangement pattern of the light guiding plate; and A2, preparing the film according to grid points arrangement pattern.

The embodiment of the present disclosure provides a backlight module comprising a light guiding plate fabricated according to the fabricating method of the light guiding plate.

The embodiment of the present disclosure provides a display device comprising the backlight module.

According to present disclosure, since the mold for the light guiding plate is not etched directly, but the grid points is formed on the layer of photosensitive resist applied on the mold, therefore the grid points on the light guiding plate can be made without damaging the surface of the mold for the light guiding plate, and the cost for polishing the mold surface is saved and the overall process is simplified.

### BRIEF DESCRIPTION OF THE DRAWINGS

The accompanying drawings of technical solutions of the present disclosure or the prior art are briefly described as following for better illustration of the technical solutions of the present disclosure or the prior arts. It is apparent that the accompanying drawings as described below are mere illustrations for some embodiments of the technical solutions of the present disclosure and thus other accompanying drawings are readily conceivable based on these accompanying drawings for the skilled in the art without creative works.
Fig. 1 is a flow chart showing a fabricating method of grid points on light guiding plate according to a first embodiment of the present disclosure;
Fig. 2 is a plan view of the grid points on light guiding plate fabricated by a fabricating method of grid points on the light guiding plate according to the first embodiment of the present disclosure;
Fig. 3 is a partial sectional view of the grid points on light guiding plate fabricated by a fabricating method of grid points on the light guiding plate according to the first embodiment of the present disclosure; and
Fig. 4 is a flow chart showing a fabricating method of light guiding plate according to a second embodiment of the present disclosure.

### DETAILED DESCRIPTION OF THE PREFERRED EMBODIMENTS

The technical solutions of embodiments of the present disclosure will be described in more detail with reference to the accompanying drawings. It is apparent that the embodiments as described are merely a part of embodiments of the present disclosure and do not represent all embodiments. All other embodiments readily conceivable by the skilled in the art based on the described embodiments of the present disclosure without creative works fall into the protection scope of the present disclosure.

### First Embodiment

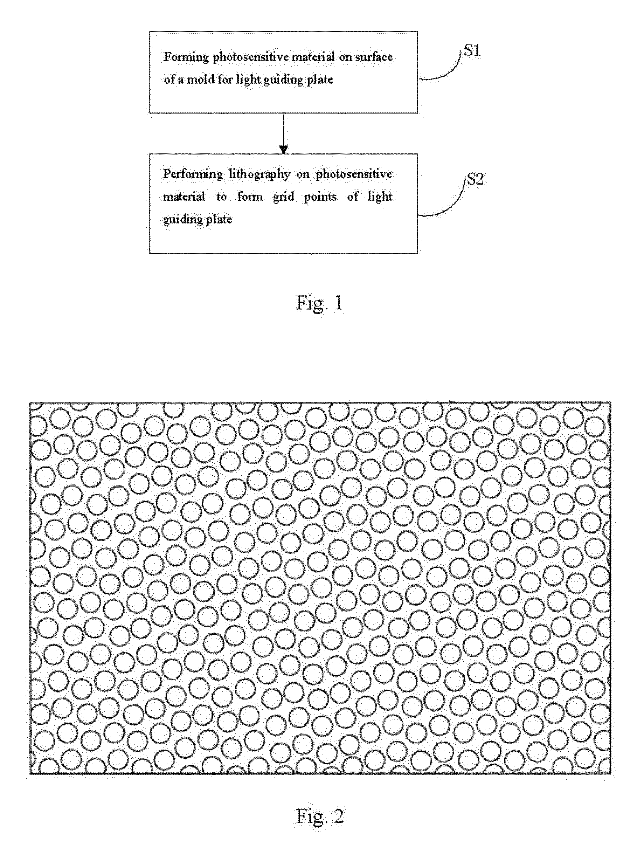

Referring to Fig. 1, the first embodiment of the present disclosure provides a fabricating method of grid points on the light guiding plate. The method includes following steps: S1, a layer of photosensitive resin is formed on a mold for the light guiding plate; and S2, the layer of photosensitive resin is subjected to a photolithography process to form grid points on the light guiding plate.

In one example, the step of S1 further includes following steps: S11, the mold for the light guiding plate is subjected to an arefaction treatment in order to improve adhesiveness of a photosensitive resin to be applied; S12, applying a layer of photosensitive resin on the surface of the mold for light guiding plate; and S13, baking the layer of photosensitive resin into a semi-cured state by a soft baking method so as to remove solvent from the photosensitive resin.

In one example, the step of S2 further includes following steps: S21, the photosensitive resin is subjected to a sequential exposing process by irradiating UV (ultraviolet) lights and a developing process using a film formed with grid points arrangement pattern as a mask in order to form grid points pattern on the photosensitive resin. The photosensitive resin is then cured, and residual solvent and moist is removed. During exposure, the pattern on the film is aligned with positions on the photosensitive resin where the grid points will be formed.

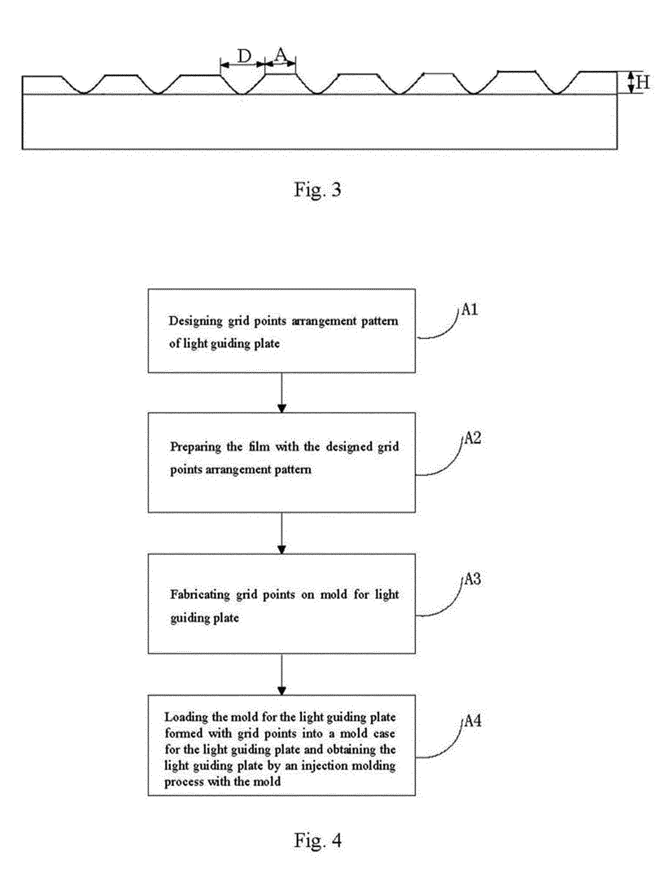

Fig. 2 and Fig. 3 show the top view and sectional view of the grid points on the light guiding plate using the method described as above, respectively. As shown in Figs. 2 and 3, each grid point on the light guiding plate is a dome like recess with a diameter D. However, the present disclosure is not limited thereto and each grid point can have other shapes such as cylinder like recess, cubic like recess, elliptical cylinder like recess or an irregular recess with an indented sectional shape.

### Second Embodiment

As shown in Fig. 4, based on the first embodiment, the second embodiment of the present disclosure provides a fabricating method of light guiding plate including following steps: A1, designing a grid points arrangement pattern on light guiding plate; A2, making a film with the grid points arrangement pattern; A3, fabricating grid points on the mold for the light guiding plate using the method according to the first embodiment; and A4, loading the mold formed with the grid points for the light guiding plate into a mold case, and performing injection molding to form the light guiding plate.

### Example 1

In case of fabricating a light guiding plate for a backlight module in a cell phone with an effective light emitting size of 2.4 inch, a grid points arrangement pattern as following can be adopted by referring to Fig. 2 and Fig. 3. Each grid point is a recess with a dome shape having a diameter D of 0.04 mm and a depth H of 0.1 mm. Grid points are arranged with equal spacing with a minimum edge to edge distance A of 0.005 mm. The fabricating accuracy for the diameter D is within ±0.002 mm, the fabricating accuracy for the diameter D is within ±0.001 mm and repeatability is 98% or more. The luminance of the light guiding plate according to the present disclosure can improved by 5% compared with the light guiding plate in which the grid points are made by chemical etching method. Due to factors such as fabricating tolerance, the grid points as shown in Fig. 3 may not have exactly the same shape.

### Example 2

In case of fabricating a light guiding plate for a backlight module in a cell phone with a VA region size of 2.4 inch, a grid points arrangement pattern as following can be adopted by referring to Fig. 2 and Fig. 3. Each grid point is a recess with a dome shape having a diameter D of 0.04-0.18 mm and a depth H of 0.1 mm. Grid points are arranged with equal spacing with a minimum edge to edge distance A of 0.3 mm. The fabricating accuracy for the diameter D is within ±0.003 mm, the fabricating accuracy for the diameter D is within ±0.001 mm and repeatability is 98% or more. The luminance of the light guiding plate according to the present disclosure can improved by 4% compared with the light guiding plate in which the grid points are made by chemical etching method.

### Third Embodiment

The third embodiment of the present disclosure provides a backlight module including a light guiding plate fabricated using the method according to the second embodiment.

### Fourth Embodiment

The fourth embodiment of the present disclosure provides a display device such as liquid display, electronic paper, OLED panel or other product with display functionality including the backlight module according to the third embodiment.

As shown in Fig. 2 and Fig. 3, the grid points fabricated with the method according to first embodiment have substantially same shape and smooth surface with a repeatability of 98% or more and a high fabricating accuracy of depth. The process for making mold is simplified by omitting the step of etching the mold, thus the mirror surface of the mold can be reused and the cost for polishing the used mold is saved, which simplified the fabricating process of the gird points on light guiding plate. The fabricated grid points can survive temperatures up to 350 °C and have a hardness up to 40 HRC±5 (HRC refers to Rockwell hardness), thus fully satisfying requirements for the molding process. The mold can have a life cycle up to 250 thousands times and the luminance of the light guiding plate can be improved by 4 % or more with a uniformity of 85% or more.

The above embodiments are intended only to illustrate the present invention and not limit the present invention. Various modifications and variations can be made by the skilled in the art without departing the spirit and scope of the present invention, such that all those equivalent solutions also fall into protection scope of the present invention which is defined by appended claims.

## Claims

1. A fabricating method of grid points on a light guiding plate, comprising following steps of:
S1, forming a layer of photosensitive material on a mold for the light guiding plate; and
S2, performing photolithography on the photosensitive material in order to form grid points on the light guiding plate.

2. The method according to claim 1, wherein the photosensitive material is a photosensitive resist.

3. The method according to claim 2, wherein the step of S1 further comprises following steps of:
S 11, performing arefaction on the mold for the light guiding plate;
S12, applying the photosensitive resist on the surface of the mold for the light guiding plate; and
S 13, removing a solvent in the photosensitive resist.

4. The method according to claim 3, wherein in the step of S13, the solvent in the photosensitive resist is removed by a soft baking method.

5. The method according to claim 2, wherein the step of S2 further comprises following steps of:
using a film formed with grid points arrangement pattern as a mask,
sequentially performing exposing and developing process on the photosensitive resin in order to form a grid points pattern on the photosensitive resin, and
curing the photosensitive resist and removing residual solvent and moisture.

6. The method according to claim 5, wherein in step S22, the photosensitive resist is exposed with UV radiation.

7. A fabricating method of a light guiding plate, comprising following steps of:
A3, fabricating grid points on the mold for the light guiding plate according to one of the claims 1-6; and
A4, loading the mold for the light guiding plate formed with grid points into a mold case for the light guiding plate and obtaining the light guiding plate by an injection molding process with the mold.

8. The method according to claim 7, further comprising following steps prior to the step of A3:
A1, designing the grid points arrangement pattern of the light guiding plate; and
A2, preparing the film with the designed grid points arrangement pattern.

9. A backlight module comprising a light guiding plate fabricated according to the fabricating method of claim 7 or 8.

10. A display device comprising the backlight module according to claim 9.
